(19) Europäisches Patentamt / European Patent Office / Office européen des brevets

(11) **EP 2 624 296 A1**

(12) **DEMANDE DE BREVET EUROPEEN**

(43) Date de publication:
**07.08.2013 Bulletin 2013/32**

(51) Int Cl.:
*H01L 23/58* (2006.01)  *G06F 21/75* (2013.01)

(21) Numéro de dépôt: **13153728.4**

(22) Date de dépôt: **01.02.2013**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **06.02.2012 FR 1251076**

(71) Demandeur: **Altis Semiconductor**
**91105 Corbeil Essonnes Cedex (FR)**

(72) Inventeurs:
• **Cioranesco, Jean-Michel**
  **75017 Paris (FR)**
• **Naccache, David**
  **75018 PARIS (FR)**

(74) Mandataire: **Hervouet, Sylvie et al**
**Feray Lenne Conseil**
**Le Centralis**
**63, avenue du Général Leclerc**
**92340 Bourg-la-Reine (FR)**

(54) **Protection d'un circuit integre contre des attaques invasives**

(57) L'invention concerne une architecture de protection pour circuit intégré contre des attaques invasives. L'architecture comprend une matrice de cellules logiques (1) comportant chacune une pluralité d'entrées/sorties associée chacune à une ligne conductrice, et des moyens de routage reconfigurables pour sélectionner un couple d'entrée/sortie et permettre une connexion électrique de chaque cellule logique à deux autres cellules logiques. Les moyens de routage sont reconfigurés périodiquement à partir d'informations de reconfiguration spécifiques à chaque cellule, pour connecter électriquement une pluralité des cellules logiques selon un circuit de connexion différent d'une période de fonctionnement à l'autre, chaque circuit de connexion formant un circuit Hamiltonien entre une cellule (1E) d'entrée fixe et une cellule (1S) de sortie fixe, et la reconfiguration pour une période donnée ($t_1$) s'effectuant grâce à un message transitant selon le circuit Hamiltonien associé à une période précédente ($t_0$), le message comportant les informations de reconfiguration spécifiques.

FI G.2a

EP 2 624 296 A1

FI G.2 b

**Description**

La présente invention est relative au domaine de la micro-électronique, et concerne plus particulièrement la protection des circuits intégrés contre les attaques dites invasives.

Il existe aujourd'hui deux principaux types d'attaques invasives visant à perturber le fonctionnement normal d'un circuit intégré ou son intégrité :

Un premier type d'attaques, connu sous le nom de rétro-conception, permet la compréhension de la structure du composant électronique réalisé sous forme de circuit intégré et de ses fonctions. L'attaquant va étudier les circuits des différents niveaux de métaux du circuit intégré afin de reconstituer les différentes parties de ce circuit. Pour ce faire, l'attaquant dispose d'un certain nombre de techniques de laminage (abrasive, chimique, électrochimique, gravure plasma, faisceau d'ions focalisés ou FIB (initiale anglo-saxonnes mises pour « Focused Ion Beam »)...) lui permettant d'accéder aux différents niveaux du circuit et de les observer. La rétro-conception conduit certes à la destruction irréversible des parties du circuit intégré analysées, mais permet de révéler l'intégralité de la structure du circuit.

Un autre type d'attaques appelé court-circuitage consiste à établir ou rompre des contacts afin d'espionner des signaux à l'intérieur du composant, et/ou d'injecter des signaux de test et d'observer les réponses à ces signaux de test. Les contacts sont établis soit avec de très fines électrodes (technique dite du court-circuitage par micro-sondage) pour une précision de l'ordre de 0,4 $\mu$m, soit par faisceau d'ions focalisés pour une précision de l'ordre de 10 nm qui, en plus de permettre le micro-sondage permet de modifier le circuit. Ce type d'attaques permet d'accéder à des informations sensibles telles qu'une clé secrète de cryptage ou le contenu de mémoires.

Différentes méthodes ont déjà été proposées pour se protéger contre de telles attaques invasives :

Des méthodes dites passives consistent à ajouter de fausses pistes conductrices. Ces méthodes ne permettent que de ralentir le processus de rétro-conception en rendant la compréhension de la structure utile plus difficile.

D'autres méthodes plus élaborées et visant à se protéger contre les deux types d'attaques précitées consistent à utiliser un bouclier actif comprenant une ou plusieurs paires de serpentins conducteurs et un circuit de contrôle qui vérifie en permanence que les serpentins n'ont pas été modifiés ou déconnectés.

Ainsi, le document US 6, 798, 234 décrit un bouclier actif composé d'un émetteur de signal, d'un récepteur de signal et d'au moins deux circuits conducteurs entre l'émetteur et le récepteur. Un interrupteur permet de basculer entre un état de mesures capacitives, et un état permettant de vérifier l'endommagement du bouclier (courts-circuits ou interruption de piste).

Le document US 7, 288, 786 propose quant à lui une solution utilisant des lignes de circuits sur plusieurs niveaux de métaux remplissant de manière systématique les vides laissés par le circuit utile, ceci afin de tromper d'éventuels attaquants et rendre la rétro-conception plus difficile, notamment l'utilisation du FIB.

Toutes les solutions connues ont le mérite de rendre les attaques invasives beaucoup plus complexes à réaliser. Néanmoins, il est toujours possible pour un attaquant disposant de suffisamment de temps et de moyens de découvrir l'architecture des circuits de protection ou boucliers actifs, de les neutraliser, et d'arriver ainsi à révéler la structure du composant électronique.

La présente invention a pour but d'améliorer encore la protection d'un circuit intégré en proposant une architecture de protection modifiable dynamiquement.

Plus précisément, la présente invention a pour objet une architecture de protection d'au moins un circuit intégré formé sur au moins un substrat contre des attaques invasives, telle que définie dans la revendication 1.

On entend par période de fonctionnement la durée nécessaire à l'exécution de l'ensemble des instructions réalisées par les cellules logiques, depuis la cellule d'entrée jusqu'à la cellule de sortie, pour faire transiter un message. Les microprocesseurs ayant des horloges de l'ordre du MHz au GHz, cette durée peut être de l'ordre de la nanoseconde à la microseconde selon les technologies actuelles.

Chaque cellule logique est de préférence apte à extraire, sur une période courante de fonctionnement, l'information de reconfiguration spécifique comprise dans le message de reconfiguration transitant depuis la cellule d'entrée fixe jusqu'à la cellule de sortie fixe selon le circuit Hamiltonien associé, et à reconfigurer, à l'issue de la période courante de fonctionnement, ses moyens de routage conformément à l'information de reconfiguration reçue, de sorte qu'à la période de fonctionnement suivante, lesdites cellules logiques soient connectées électriquement selon un nouveau circuit Hamiltonien établi entre ladite cellule d'entrée fixe et ladite cellule de sortie fixe.

Chaque cellule logique peut intégrer en outre des moyens de cryptage aptes à chiffrer une signature comprise dans le message de reconfiguration avant transmission dudit message de reconfiguration à la cellule logique suivante.

Selon encore certains autres modes de réalisation conformes à l'invention, l'architecture peut comporter également une ou plusieurs des caractéristiques suivantes :

- au moins une ligne conductrice entre deux cellules logiques dudit ensemble comprend au moins une portion en forme de serpentin ;

- au moins une ligne conductrice entre deux cellules logiques dudit ensemble s'étend sur un ou plusieurs niveaux de métal dudit au moins un circuit intégré ;
- les cellules logiques de ladite matrice sont réparties sur plusieurs substrats composant un même circuit intégré ;
- la matrice peut comporter une ou plusieurs cellules logiques leurres, exclues systématiquement du circuit Hamiltonien associé à chaque période de fonctionnement.
- l'architecture de protection peut comporter plusieurs matrices comportant chacune un ensemble de cellules logiques à moyens de routage reconfigurables, les moyens de routage des cellules d'un même ensemble étant aptes à être reconfigurés à chaque période de fonctionnement pour permettre la connexion électrique des cellules du même ensemble selon un nouveau circuit de connexion;
- dans ce dernier cas, au moins une cellule logique peut être commune à au moins deux matrices.

La présente invention et les avantages qu'elle procure seront mieux compris au vu de la description suivante, faite en référence aux figures annexées, dans lesquelles :

- la figure 1 illustre sous forme de schéma bloc fonctionnel, une cellule logique élémentaire comprise dans une architecture conforme à un premier mode de réalisation de l'invention;
- les figures 2a et 2b représentent un exemple du passage d'un premier circuit Hamiltonien à un deuxième circuit Hamiltonien sur deux périodes successives de fonctionnement pour une architecture possible conforme à l'invention, comprenant 16 cellules logiques élémentaires ;
- la figure 3 illustre un exemple de message de reconfiguration ;
- les figures 4a et 4b illustrent sous forme simplifiée des exemples de configurations possibles pour l'agencement d'une architecture de protection selon l'invention ;
- la figure 5 représente schématiquement un autre exemple du passage d'un premier circuit Hamiltonien à un deuxième circuit Hamiltonien sur deux périodes successives de fonctionnement pour une architecture possible conforme à l'invention, comprenant 16 cellules logiques élémentaires intégrant une fonctionnalité de cryptage.

La protection d'un circuit intégré contre les attaques invasives selon l'invention repose sur l'utilisation d'une matrice de cellules logiques élémentaires comportant chacune des moyens de routage reprogrammables de façon à permettre aux cellules d'être connectées entre elles selon une topologie de connexion reconfigurable périodiquement.

Les cellules logiques élémentaires sont intégrées directement au niveau du substrat en silicium du circuit intégré à protéger et comporte chacune une pluralité d'entrées/sorties, chaque entrée/sortie étant associée à une ligne conductrice formée dans le circuit intégré.

Le nombre d'entrées/sorties peut varier en fonction de l'architecture du circuit de vérification que l'on choisit. Cependant les cellules logiques ont toutes en commun leurs fonctionnalités de routage et d'identification de leur prochaine reconfiguration.

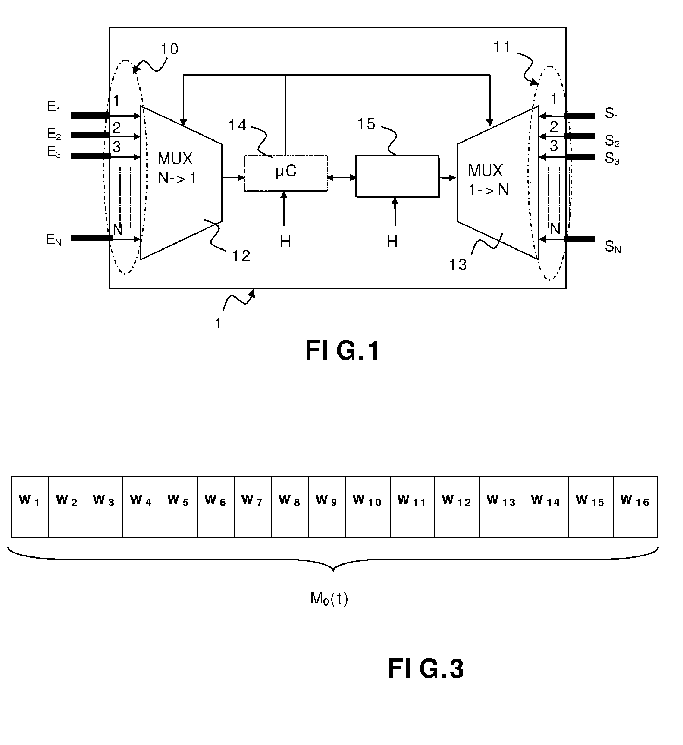

La figure 1 illustre à titre d'exemple non limitatif le schéma logique d'une cellule logique élémentaire 1 à N entrées/sorties 10, 11 permettant une première mise en oeuvre possible de l'invention. Afin de pouvoir acheminer le signal à travers ses N entrées/sorties 10 et 11, chaque cellule programmable 1 est composée de moyens de routage reconfigurables représentés ici sous forme de plusieurs blocs logiques comportant :

- Un dispositif 12 de multiplexage N vers 1 et un dispositif 13 de multiplexage 1 vers N pour commander respectivement les N entrées/sorties 10 et 11 ;
- Un contrôleur 14 associé à une horloge, apte à commander la configuration des dispositifs de multiplexage 12 et 13 ;
- un registre 15 pour sauvegarder la prochaine configuration de routage de la cellule.

Dans une implémentation avantageuse de l'invention qui sera détaillée par la suite, le registre 15 peut être combiné à un moyen de cryptage, et sauvegarder certains paramètres nécessaires aux opérations cryptographiques.

Chaque entrée/sortie 10, 11 est reliée électriquement à une ligne conductrice spécifique représentée en trait épais sur la figure 1. En fonctionnement, les moyens de routage de chaque cellule constituant la matrice sont aptes à sélectionner une entrée et une sortie spécifiques, en fonction d'une information de configuration stockée dans le registre 15, de manière à permettre à chaque cellule d'être connectée électriquement entre deux autres cellules de la matrice. Par exemple, si le contrôleur 14 sélectionne l'entrée numérotée 1 du dispositif de multiplexage 12, et la sortie numérotée 2 du dispositif de multiplexage 13, la cellule logique 1 de la figure sera connectée électriquement d'une part, à une sortie d'une deuxième cellule logique par l'intermédiaire de la ligne conductrice $E_1$, et d'autre part, à une entrée d'une troisième cellule logique par l'intermédiaire de la ligne conductrice $S_2$.

Conformément à l'invention, l'architecture de protection va être commandée de façon à ce que les cellules de la matrice soient connectées entre elles selon un circuit Hamiltonien établi entre une première desdites cellules constituant une cellule d'entrée fixe et une deuxième desdites cellules constituant une cellule de sortie fixe, et reconfigurable périodiquement.

On rappelle qu'un circuit Hamiltonien dans une matrice comportant N noeuds ou sommets, ici représentés par les cellules logiques élémentaires, est un circuit passant une fois seulement par chacun des noeuds ou sommets de la matrice. Pour toute matrice comportant au moins quatre noeuds ou sommets, dont deux sont considérés comme des noeuds d'entrée et de sortie fixes, il est donc possible de relier les noeuds entre eux selon plusieurs circuits Hamiltoniens.

Cette propriété va être exploitée ici en reconfigurant de manière périodique les moyens de routage associés à chaque cellule, de façon à ce que les cellules soient connectées à chaque période selon une topologie de connexion Hamiltonienne différente entre une même cellule d'entrée et une même cellule de sortie. Pour ce faire, chaque cellule est reconfigurée en faisant transiter dans chaque cellule de la matrice, pendant une période de fonctionnement, un message de reconfiguration comportant les informations de reconfiguration spécifiques à chaque cellule. Comme les cellules sont toujours connectées entre elles selon un circuit Hamiltonien, on garantit ainsi que chaque cellule de la matrice recevra bien l'information de reconfiguration qui lui est destinée. En conséquence, à l'issue de la période de fonctionnement, lorsque le message a transité successivement dans chaque cellule, chaque cellule est en mesure d'extraire l'information de reconfiguration qui lui est propre, et de reconfigurer ses propres moyens de routage en fonction de cette information de reconfiguration. Au cycle de fonctionnement suivant, les cellules sont connectées les unes aux autres selon un nouveau circuit Hamiltonien. A la mise sous tension du circuit intégré, la matrice de cellules se configure dans sa position d'initialisation. Chaque cellule a sa configuration par défaut enregistrée dans son registre propre. Ceci assure que chaque cellule recevra la première information de reconfiguration.

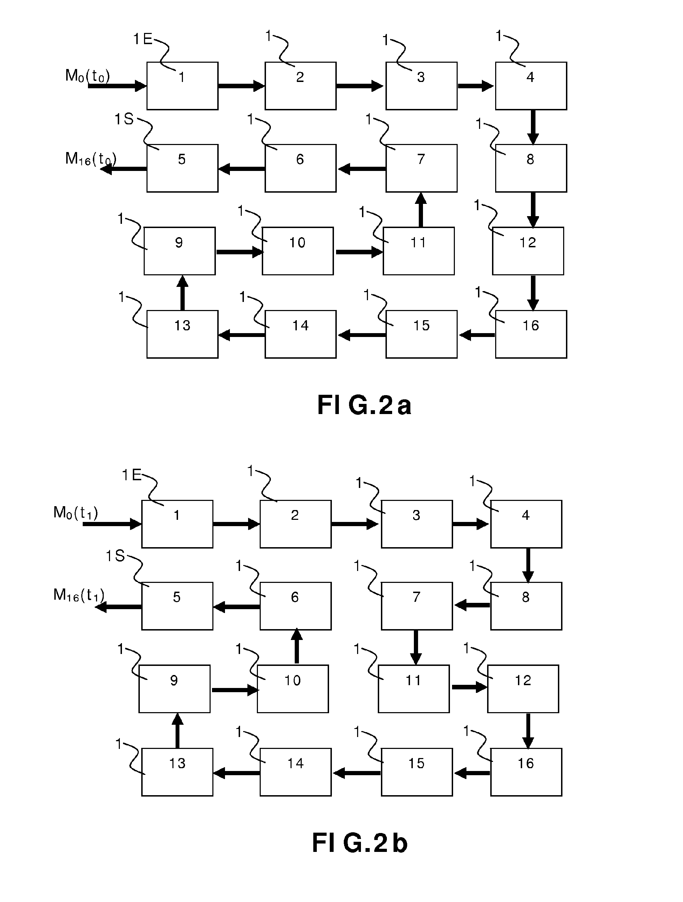

Pour illustrer le principe précédent, on se reportera aux figures 2a, 2b et 3 pour lesquelles on a supposé dans la suite, de manière non limitative, que la matrice selon l'invention est composée de 16 cellules logiques élémentaires 1 reprogrammables, chaque cellule ayant 4 entrées/sorties, et disposant ainsi de 16 possibilités de routage, qu'il sera possible de programmer sur 4 bits (Pour une cellule à N entrées/sorties, elle aura N(N-1) possibilités de routage).

Plus précisément, on a représenté sur les figures 2a et 2b deux topologies distinctes d'interconnexion Hamiltonienne des cellules de la matrice, respectivement à une période courante de fonctionnement notée $t_0$, et à la période de fonctionnement suivante notée $t_1$. Pour les deux figures 2a et 2b, les cellules 1 sont représentée par un numéro d'identification (1 à 16). Dans l'exemple, la cellule 1 constitue la cellule d'entrée fixe 1E, et la cellule 5 constitue la cellule de sortie fixe 1S. Durant la période courante de fonctionnement $t_0$, une sortie de chaque cellule est connectée à l'entrée d'une autre cellule en suivant le circuit Hamiltonien suivant (figure 2a) :
1->2->3->4->8->12->16->15->14->13->9->10->11->7->6->5

A la période de fonctionnement suivante $t_1$, une sortie de chaque cellule est connectée à l'entrée d'une autre cellule en suivant le nouveau circuit Hamiltonien suivant (figure 2b) :
1->2->3->4->8->7->11->12->16->15->14->13->9->10->6->5

Le passage de la topologie d'interconnexion selon la figure 2a à la topologie d'interconnexion selon la figure 2b va à présent être détaillé :

On note $M_0(t_0)$ le message de reconfiguration qui est généré et injecté en entrée de la cellule d'entrée 1E, et qui va transiter, lors de la période $t_0$ dans le circuit Hamiltonien de la figure 2a. Ce message de reconfiguration pourra par exemple être décomposé, comme illustré sur la figure 3, en autant d'informations de reconfiguration que de nombre de cellules. Ainsi, chaque message $M_0(t)$ envoyé sur une période de fonctionnement t donnée comporte ici 16 informations de reconfiguration, chaque information de reconfiguration $w_i$ correspondant au prochain routage de la cellule i. Si l'on suppose, à titre non limitatif, un fonctionnement synchrone de l'ensemble des cellules, le message est transmis à la cellule suivante à chaque coup d'horloge. Dans notre exemple, 16 coups d'horloge sont nécessaires pour permettre à toutes les cellules i de récupérer dans le message qu'elles reçoivent, l'information de reconfiguration $w_i$ qui les concerne, et que chaque cellule stocke dans le registre 15 (figure 1) qui lui est propre. Au coup d'horloge suivant, chaque cellule est apte à reconfigurer ses moyens de routage conformément à l'information de reconfiguration. Le coup d'horloge suivant correspond au début d'une nouvelle période de fonctionnement $t_1$ dans laquelle la topologie de connexion des cellules a changé. Le cycle recommence, en injectant sur la cellule d'entrée 1E un nouveau message de reconfiguration $M_0(t_1)$ qui va cette fois-ci circuler en suivant le circuit Hamiltonien de la figure 2b.
On remarque dans cet exemple que seules quelques cellules, à savoir les cellules 7, 8, 10 et 11, ont dû finalement recevoir, par le message $M_0(t_0)$, une information de reconfiguration destinée à leur faire changer de routage, pour passer de la topologie selon la figure 2a à la topologie selon la figure 2b.

Il convient de noter que la périodicité de reconfiguration et de fonctionnement des cellules n'est pas forcément constante mais peut varier, notamment pour autoriser un fonctionnement asynchrone.

En modifiant ainsi la topologie d'interconnexion des différentes cellules logiques de la matrice, seules les cellules d'entrée et de sortie restant inchangées, il devient beaucoup plus difficile pour un attaquant éventuel de réaliser un court-circuit entre deux points quelconque de la matrice.

En outre, la géométrie des lignes conductrices

(E$_1$ à E$_N$ et S$_1$ à S$_N$ sur la figure 1) peut être avantageusement prévue pour rendre plus difficile la compréhension de la structure en cas d'attaque par rétro-conception.

On peut par exemple prévoir qu'au moins une ligne conductrice entre deux cellules logiques comprenne au moins une portion en forme de serpentin.

Alternativement ou en combinaison, on peut prévoir qu'au moins une ligne conductrice entre deux cellules logiques de la matrice s'étende sur un ou plusieurs niveaux de métal du circuit intégré.

On peut ainsi utiliser la géométrie de ces lignes conductrices pour remplir au mieux les vides laissés par le circuit utile du composant électronique à protéger sur plusieurs niveaux de métal.

On peut en outre prévoir que la matrice comporte également une ou plusieurs cellules logiques leurres, exclues systématiquement du circuit Hamiltonien associé à chaque période de fonctionnement.

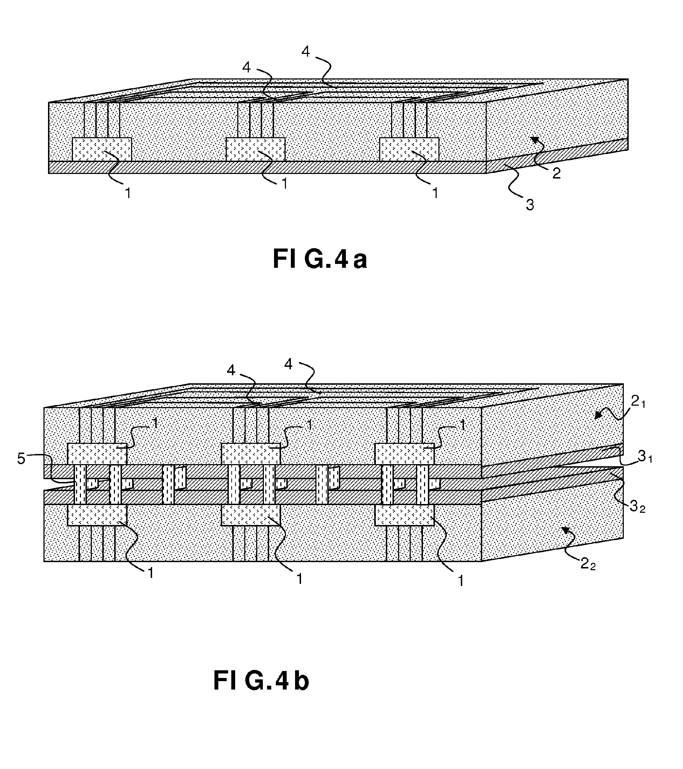

L'architecture de protection selon l'invention peut par conséquent adopter différentes formes selon la nature du circuit à protéger : Elle peut par exemple entourer le circuit utile et/ou être enchevêtrée dans le circuit utile. La figure 4a donne très schématiquement un exemple d'architecture de protection dans laquelle trois cellules logiques 1 ont été placées au niveau du substrat 3 d'un circuit intégré avec un circuit utile 2 sur plusieurs niveaux de métal. Sur cette figure, différentes lignes conductrices 4 ont été représentées, aptes à connectées électriquement les cellules entre elles selon la configuration des moyens de routage de chaque cellule.

Si le composant à protéger comporte plusieurs substrats 3$_1$, 3$_2$ comme dans le cas représenté schématiquement sur la figure 4b, on optera pour répartir les cellules logiques 1 sur ces substrats de manière que l'architecture de protection entoure et/ou s'enchevêtre dans les circuits utiles 2$_1$, 2$_2$ associés à chaque substrat. Dans ce cas, des connexions 5 traversant le substrat (connues sous la terminologie anglo-saxonne TSV, through silicon via) sont prévues au niveau des substrats pour permettre l'interconnexion des différentes lignes conductrices et des différentes cellules logiques.

Par souci de compréhension, les lignes conductrices 4 ont été représentées dans les deux figures 4a et 4b comme s'étendant principalement sur la dernière couche de métal associée au substrat. En outre, les connexions entre les cellules logiques 1 et le(s) circuit(s) utile(s) n'ont pas été représentées pour ne pas surcharger les figures, mais il convient de noter que ces éléments partagent bien entendu différentes ressources telles que les alimentations, la masse électrique et les signaux d'horloge.

Dans certains cas très élaborés, l'architecture de protection pourra même comporter plusieurs matrices comportant chacune un ensemble de cellules logiques à moyens de routage reconfigurables, les moyens de routage des cellules d'un même ensemble étant aptes à être reconfigurés à chaque période de fonctionnement pour permettre la connexion électrique des cellules du même ensemble selon un nouveau circuit Hamiltonien. Les différentes matrices pourront fonctionner en parallèle et de façon indépendante, voire mettre en commun leurs ressources : en particulier, au moins une cellule logique peut être commune à deux matrices ou plus. Dans ce cas, la ou les cellules communes à plusieurs matrices devront avoir une structure logique adaptée par rapport à celle présentée à la figure 1. On pourra par exemple envisager de dédoubler les entrées/sorties des cellules qui doivent être communes à deux matrices.

Il convient de noter que l'architecture de protection selon l'invention, bien que présentant des similarités avec des matrices FPGA (Initiales anglo-saxonnes mises pour « Field Programmable Gate Array ») à reconfiguration dynamique, réseaux de cellules aptes à être reprogrammées partiellement en fonctionnement, en diffère en fait non seulement par sa nature, mais aussi par sa fonction. En effet, les cellules et les lignes conductrices permettant de relier les cellules entre elles sont constituées ici de couches de métallisations fixes à géométrie quelconque implémentées directement en ASIC (initiales anglo-saxonnes mises pour Application Specific Integrated Circuit) et non sur une base de cellules SRAM (Initiales anglo-saxonnes mises pour Static Random Access Memory) comme c'est le cas pour la plupart des matrices FPGA. De ce fait, la fréquence de fonctionnement de la matrice selon l'invention sera plus haute et la consommation de courant plus faible qu'un équivalent FPGA.

Le mode de reconfiguration selon l'invention diffère également de celui adopté pour une matrice FPGA puisque, dans ce premier mode de réalisation, c'est le message circulant à travers les cellules logiques qui porte l'information de reconfiguration. Enfin, la finalité est également différente puisqu'il s'agit, dans le cas présent, de modifier dynamiquement le chemin de routage des cellules logique pour se prémunir des attaques invasives. En vérifiant la bonne réception du message sur la cellule de sortie, on s'assure en effet qu'aucun court-circuitage n'a été réalisé.

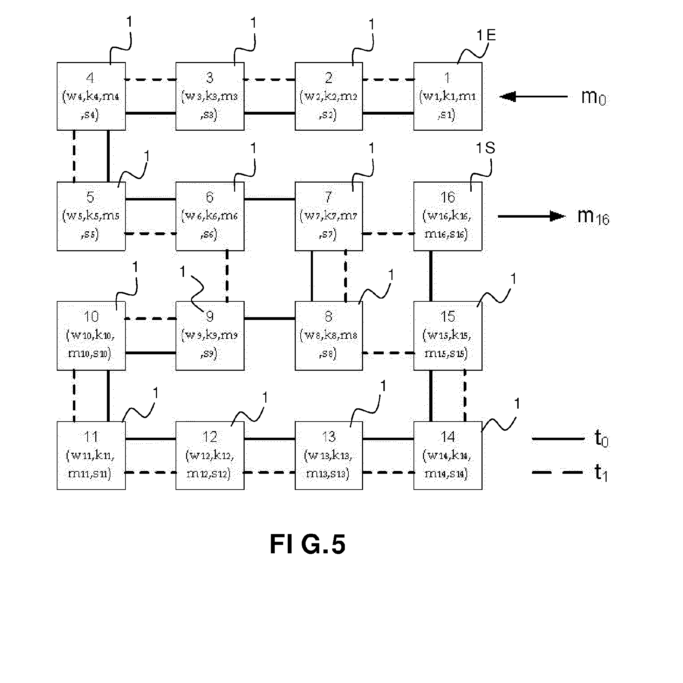

Une variante de réalisation de l'architecture de protection, conforme au premier mode de réalisation de la présente invention, va à présent être décrite en référence à la figure 5. Il s'agit ici de protéger l'architecture en elle-même contre une manipulation des cellules logiques en intégrant à chacune de ces cellules une fonction cryptographique propre.

La matrice de cellules est composée de la même manière que précédemment à la différence que chaque cellule est capable d'opérer des fonctions cryptographiques à l'aide d'une clé et de paramètres propres à chaque cellule. Comme cela a déjà été indiqué précédemment, il suffit de combiner le registre 15 (figure 1) de chaque cellule logique 1 à un moyen de cryptage, et sauvegarder certains paramètres nécessaires aux opérations cryptographiques. Le message de reconfiguration transmis à travers les circuits Hamiltoniens sera donc ici composé comme précédemment de l'information de reconfiguration des cellules, mais également d'une signature qui sera chiffrée successivement par chaque cellule. Le composant électronique ou un coprocesseur protégé par l'architecture vérifiera à la fin de chaque période de fonctionnement la validité de la signature chiffrée par toutes les cellules. Il pourra ainsi détecter toute modification dans le réseau de cellule et stopper le fonctionnement du microprocesseur.

Pour illustrer ce deuxième mode de réalisation, on reprend l'exemple non limitatif d'une matrice composée de 16 cellules élémentaires reprogrammables, chaque cellule ayant 4 entrées/sorties et intégrant une fonction cryptographique individuelle. La figure 5 illustre le circuit Hamiltonien reliant les différentes cellules à la période de fonctionnement $t_0$ (connexion en traits pleins entre les différentes cellules logiques 1), ainsi que le circuit Hamiltonien reliant ces mêmes cellules à la période de fonctionnement suivante $t_1$ (connexion en traits discontinus entre les différentes cellules logiques 1).

On note dans la suite :

- i, l'identifiant de position de chaque cellule à l'intérieur du circuit Hamiltonien.
- $s_i$, une variable d'état associée à chaque cellule i et initialisée à zéro.
- $w_i$, l'état représentatif de l'information de configuration de chaque cellule i (12 états dans le cas de cellules 4 entrées/sorties).
- $k_i$, une clé de chiffrement fixe associée à chaque cellule i.
- $m_o$, le message de reconfiguration généré et alimentant à chaque période de fonctionnement la cellule d'entrée 1E fixe de la matrice (dans l'exemple, la cellule d'identifiant 1).
- $m_{16}$, le message de reconfiguration en sortie de la cellule d'entrée 1S fixe de la matrice à chaque période de fonctionnement (dans l'exemple, la cellule d'identifiant 16).
- $m_{i-1}$, le message de reconfiguration injecté dans chaque cellule d'identifiant i.

A chaque période de fonctionnement, chaque cellule i calcule le message qu'elle va transmettre à la cellule suivante selon sa fonction de cryptage F, soit

$$m_i = F(w_{i,t}, k_i, i, m_{i-1}, s_i)$$

et remet à jour sa propre variable d'état (correspondant à la configuration de routage qu'elle devra avoir au cycle de fonctionnement suivant) selon l'équation :

$$s_{i,t+1} = G(w_{i,t}, k_i, i, m_{i-1}, s_{i,t})$$

Le message $m_i$ est alors transmis à la cellule suivante i+1.

A chaque coup d'horloge, le message est transmis à la cellule suivante qui chiffre la signature avec sa propre clé et ses paramètres. Au 16ème coup d'horloge, l'information a transité à travers toute la matrice si bien qu'au 17ème coup d'horloge, la matrice peut se reconfigurer dans un nouveau routage.

A la fin de chaque période de fonctionnement, le message en sortie de la cellule de sortie 1S, dans l'exemple le message $m_{16}$. On calcule par ailleurs la fonction cryptographique globale dans le circuit utile. Il suffit de comparer les deux valeurs obtenues pour tester l'intégrité du circuit et ainsi détecter toute modification de la matrice. La fonction cryptographique globale dépendra donc du temps puisqu'elle dépend de la configuration de la matrice, ainsi que de ses états précédents.

A la période suivante, le cycle recommence, la cellule 1E reçoit un nouveau message de reconfiguration.

## Revendications

1. Architecture de protection d'au moins un circuit intégré formé sur au moins un substrat contre des attaques invasives, **caractérisée en ce qu'**elle comporte une matrice comprenant, sur ledit au moins un substrat, un ensemble de cellules logiques (1) comportant chacune une pluralité d'entrées/sorties (10, 11) associée chacune à une ligne conductrice ($E_1$-$E_N$, $S_1$-$S_N$) et des moyens (12-15) de routage reconfigurables aptes à sélectionner un couple d'entrée/sortie pour permettre une connexion électrique de chaque cellule logique à deux autres cellules logiques quelconque dudit ensemble et une vérification de la bonne réception d'un message sur une cellule de sortie pendant une période de fonctionnement de l'architecture de protection,
**en ce que** lesdits moyens (12-15) de routage de chaque cellule logique (1) sont aptes à être reconfigurés périodiquement à partir d'une information ($w_i$) de reconfiguration spécifique à chaque cellule logique, de façon à ce qu'une pluralité desdites cellules logiques de la matrice soient connectées électriquement les unes aux autres selon un circuit de connexion différent d'une période de fonctionnement à l'autre, le circuit de connexion associé à chaque période de fonctionnement formant un circuit Hamiltonien sur l'ensemble desdites cellules logiques entre une première desdites cellules logiques constituant une cellule (1E) d'entrée fixe et une deuxième desdites cellules logiques constituant une cellule (1S) de sortie fixe, au travers duquel un message de reconfiguration comprenant lesdites informations de reconfiguration est apte à transiter.

2. Architecture de protection selon la revendication 1, **caractérisée en ce que** chaque cellule logique (1) est apte à extraire, sur une période courante de fonctionnement, l'information de reconfiguration spécifique ($w_i$) comprise dans le message de reconfiguration transitant depuis la cellule (1E) d'entrée fixe jusqu'à la cellule (1S) de sortie fixe selon le circuit Hamiltonien associé, et à reconfigurer, à l'issue de la période courante de fonctionnement, ses moyens (12-15) de routage conformément à l'information de reconfiguration reçue, de sorte qu'à la période de fonctionnement suivante, lesdites cellules logiques soient connectées électriquement selon un nouveau circuit Hamiltonien établi entre ladite cellule d'entrée fixe (1E) et ladite cellule de sortie fixe (1S).

3. Architecture de protection selon l'une quelconque des revendications 1 et 2, **caractérisée en ce que** chaque cellule logique (1) intègre en outre des moyens de cryptage aptes à chiffrer une signature comprise dans ledit message de reconfiguration avant transmission dudit message de reconfiguration à la cellule logique suivante.

4. Architecture de protection selon l'une quelconque des revendications 1 à 3, **caractérisée en ce que** la matrice comporte en outre une ou plusieurs cellules logiques leurres, exclues systématiquement du circuit Hamiltonien associé à chaque période de fonctionnement.

5. Architecture de protection selon l'une quelconque des revendications précédentes, **caractérisée en ce qu'**au moins une ligne conductrice ($E_1$-$E_N$, $S_1$-$S_N$) entre deux cellules logiques (1) dudit ensemble comprend au moins une portion en forme de serpentin.

6. Architecture de protection selon l'une quelconque des revendications précédentes, **caractérisée en ce qu'**au moins une ligne conductrice ($E_1$-$E_N$, $S_1$-$S_N$) entre deux cellules logiques (1) dudit ensemble s'étend sur un ou plusieurs niveaux de métal dudit au moins un circuit intégré.

7. Architecture de protection selon l'une quelconque des revendications précédentes, **caractérisée en ce que** les cellules logiques (1) de ladite matrice sont réparties sur plusieurs substrats ($3_1$, $3_2$) composant un même circuit intégré.

8. Architecture de protection selon l'une quelconque des revendications précédentes, **caractérisée en ce qu'**elle comporte plusieurs matrices comportant chacune un ensemble de cellules logiques à moyens de routage reconfigurables, les moyens de routage des cellules d'un même ensemble étant aptes à être reconfigurés à chaque période de fonctionnement pour permettre la connexion électrique des cellules du même ensemble selon un nouveau circuit de connexion.

9. Architecture de protection selon la revendication 8, **caractérisé en ce qu'**au moins une cellule logique est commune à au moins deux matrices.

**FIG.1**

$M_0(t)$

**FIG.3**

**FIG.2a**

**FIG.2b**

**FI G.4 a**

**FI G.4 b**

**FI G.5**

Europäisches
Patentamt

European
Patent Office

Office européen
des brevets

**RAPPORT DE RECHERCHE EUROPEENNE**

Numéro de la demande

EP 13 15 3728

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | DE 103 38 435 A1 (INFINEON TECHNOLOGIES AG [DE]) 14 avril 2005 (2005-04-14) * alinéas [0001] - [0005], [0037] - [0046]; figure 4 * | 1-9 | INV. H01L23/58 G06F21/75 |
| A | US 2010/001757 A1 (JANKE MARCUS [DE] ET AL) 7 janvier 2010 (2010-01-07) * alinéa [0001] - alinéa [0038]; figures 1-4 * | 1-9 | |
| A | WO 00/67319 A1 (INFINEON TECHNOLOGIES AG [DE]; KUX ANDREAS [DE]; SMOLA MICHAEL [DE]) 9 novembre 2000 (2000-11-09) * abrégé; figure 1 * | 7 | |
| A | US 2006/095975 A1 (YAMADA TAKAYOSHI [JP] ET AL) 4 mai 2006 (2006-05-04) * alinéa [0099] - alinéa [0120]; figures 9-18 * | 1 | |
| A | FR 2 824 648 A1 (GEMPLUS CARD INT [FR]) 15 novembre 2002 (2002-11-15) * le document en entier * | 1-9 | DOMAINES TECHNIQUES RECHERCHES (IPC) H01L G06F |
| A | EP 1 840 964 A1 (IRVINE SENSORS CORP [US]) 3 octobre 2007 (2007-10-03) * alinéas [0021] - [0029]; figures 1,2B,2C * * alinéa [0038] - alinéa [0044]; figure 5 * | 1 | |
| A | US 2003/037212 A1 (CAPPS LOUIS BENNIE [US] ET AL CAPPS JR LOUIS BENNIE [US] ET AL) 20 février 2003 (2003-02-20) * alinéa [0018] - alinéa [0035]; figures 1,2 * | 1 | |

Le présent rapport a été établi pour toutes les revendications

| Lieu de la recherche | Date d'achèvement de la recherche | Examinateur |
|---|---|---|
| Munich | 15 mars 2013 | Le Gallo, Thomas |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 13 15 3728

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-03-2013

| Document brevet cité au rapport de recherche | Date de publication | Membre(s) de la famille de brevet(s) | Date de publication |
|---|---|---|---|
| DE 10338435 A1 | 14-04-2005 | AUCUN | |
| US 2010001757 A1 | 07-01-2010 | DE 102009025412 A1<br>US 2010001757 A1 | 21-01-2010<br>07-01-2010 |
| WO 0067319 A1 | 09-11-2000 | CN 1349660 A<br>EP 1186039 A1<br>JP 2002543621 A<br>US 2003008432 A1<br>WO 0067319 A1 | 15-05-2002<br>13-03-2002<br>17-12-2002<br>09-01-2003<br>09-11-2000 |
| US 2006095975 A1 | 04-05-2006 | AUCUN | |
| FR 2824648 A1 | 15-11-2002 | FR 2824648 A1<br>WO 02093332 A1 | 15-11-2002<br>21-11-2002 |
| EP 1840964 A1 | 03-10-2007 | AUCUN | |
| US 2003037212 A1 | 20-02-2003 | AUCUN | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6798234 B

- US 7288786 B